(19) Europäisches Patentamt
European Patent Office
Office européen des brevets

(11) **EP 2 320 472 B1**

(12) **EUROPEAN PATENT SPECIFICATION**

(45) Date of publication and mention
of the grant of the patent:
**12.07.2017 Bulletin 2017/28**

(21) Application number: **09808237.3**

(22) Date of filing: **14.08.2009**

(51) Int Cl.:
***H01L 31/04*** *(2014.01)*    ***H01L 31/042*** *(2014.01)*

(86) International application number:
**PCT/JP2009/064343**

(87) International publication number:
**WO 2010/021301 (25.02.2010 Gazette 2010/08)**

(54) **SOLAR CELL MODULE**

SOLARZELLENMODUL

MODULE DE CELLULES SOLAIRES

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **22.08.2008 JP 2008214520**

(43) Date of publication of application:
**11.05.2011 Bulletin 2011/19**

(73) Proprietor: **Panasonic Intellectual Property Management Co., Ltd.**
**Osaka-shi, Osaka 540-6207 (JP)**

(72) Inventors:
• **YOSHIMINE, Yukihiro**
**Moriguchi City, Osaka 570-8677 (JP)**
• **HASHIMOTO, Haruhisa**
**Moriguchi City, Osaka 570-8677 (JP)**
• **KANNO, Hiroshi**
**Moriguchi City, Osaka 570-8677 (JP)**
• **FUKUMOCHI, Shuji**
**Moriguchi City, Osaka 570-8677 (JP)**

(74) Representative: **Addiss, John William et al**
**Mewburn Ellis LLP**
**City Tower**
**40 Basinghall Street**
**London EC2V 5DE (GB)**

(56) References cited:
EP-A1- 0 499 075      WO-A2-2008/028123
FR-A1- 2 182 642      JP-A- 2000 196 128
JP-A- 2002 305 316    JP-A- 2005 191 125
JP-A- 2006 066 762    JP-A- 2006 080 217
JP-A- 2006 310 745    JP-A- 2008 147 260

## Description

TECHNICAL FIELD

The present invention relates to a solar cell module including a plurality of solar cells connected to each other by a wiring member.

BACKGROUND ART

Solar cells are expected as new energy sources owing to their capability of directly converting clean and inexhaustibly-supplied sunlight into electricity.

In general, the output power per solar cell is several watts. Accordingly, for use of such a solar cell as a power source for a house, a building, or the like, a solar cell module is used which is capable of providing higher output power by use of a plurality of solar cells electrically connected to each other.

The plurality of solar cells are arranged in an array direction. The plurality of solar cells are electrically connected to each other by use of wiring members. To be more precise, a wiring member is arranged along the array direction on a light receiving surface of one solar cell and a back surface of another solar cell next to the one solar cell. Accordingly, the wiring member is formed to have two bent portions by being bent twice between the light receiving surface of the one solar cell and the back surface of the other solar cell.

When an end portion of a solar cell and a wiring member contact with each other in the solar cell module manufacturing process, however, a problem arises that the end portion of the solar cell may be cracked or chipped due to concentration of stress in the end portion of the solar cell.

To address this problem, a method has been proposed in which a wiring member is bent three or more times between one solar cell and another solar cell (see Patent Document 1). With this technique, concentration of stress in the end portion of the solar cell is prevented by expansion of the wiring member.

A solar cell module including several solar cells connected by a wiring member and a method of allowing the wiring member to move to allow bending or expansion of the solar cell module has been disclosed (see Patent Document 2). However it does not present a design of the wiring member to prevent bent portions of the wiring member from being damaged.

PRIOR ART DOCUMENT

PATENT DOCUMENT

Patent Document 1: Japanese Patent Application Publication No. 2005-191125
Patent Document 2: European Patent Application Publication No. EP0499075A1

SUMMARY OF THE INVENTION

Here, in general, a solar cell module has a flat plate shape and is placed along a surface of a roof or the like. Accordingly, the solar cell module may be curved as a whole in some cases due to an influence of a wind. To be more precise, when a wind blows toward a solar cell module, a center portion of the solar cell module is recessed downward. When a wind blows along the solar cell module, the center portion of the solar cell module is bulged upward.

When the solar cell module is curved upward and downward as a whole as described above, the distances between a plurality of solar cells are repetitively changed and the wiring members expand and shrink also repetitively. As a result, the bent portions of the wiring members may be damaged.

The present invention has been made in consideration of the foregoing circumstances, and an objective thereof is to provide a solar cell module in which a bent portion of each wiring member is prevented from being damaged.

A solar cell module according to a feature of the present invention is summarized as a solar cell module including a first solar cell and a second solar cell sealed between a light receiving surface protection member and a back surface protection member and electrically connected to each other by a wiring member. Each of the first solar cell and the second solar cell includes a light receiving surface facing the light receiving surface protection member and a back surface provided on an opposite side to the light receiving surface and facing the back surface protection member, the wiring member is arranged on the light receiving surface of the first solar cell and the back surface of the second solar cell so as to bridge therebetween, the wiring member includes two bent portions formed between the first solar cell and the second solar cell, and one of the two bent portions having a larger distance from a neutral surface has a larger curvature radius than the other bent portion.

The neutral surface is a plane to which no tensile stress or compressive stress caused by curving of the light receiving surface protection member and the back surface protection member is applied.

In the solar cell module according to the present invention, the wiring member may be bent gently at a location far from the neutral surface. More specifically, the wiring member may be bent gently at a portion to which a large stress is more likely to be applied when the light receiving surface protection member and the back surface protection member are curved upward or downward. Hence, the wiring member can be prevented from being damaged at the other bent portion.

BREIF DESCRIPTION OF THE DRAWINGS

[Fig. 1] Fig. 1 is a side view of a solar cell module 100 according to an embodiment of the present invention.
[Fig. 2] Fig. 2 is a plan view of a solar cell 10 according to the embodiment of the present invention.
[Fig. 3] Fig. 3 is a plan view of a solar cell string 1 according to the embodiment of the present invention.
[Fig. 4] Fig. 4 is a cross sectional view taken along a line A-A in Fig. 3.
[Fig. 5] Fig. 5 is a view for explaining a manufacturing method of the solar cell module 100 according to the embodiment of the present invention.

MODES FOR CARRYING OUT THE INVENTION

Hereinafter, embodiments of the present invention will be described by using the drawings. In the following description of the drawings, same or similar reference signs denote same or similar elements and portions. In addition, it should be noted that the drawings are schematic and ratios of dimensions and the like are different from actual ones. Therefore, specific dimensions and the like should be determined in consideration of the following description. Moreover, the drawings also include portions having different dimensional relationships and ratios from one drawing to another.

<Structure of the Solar Cell Module>

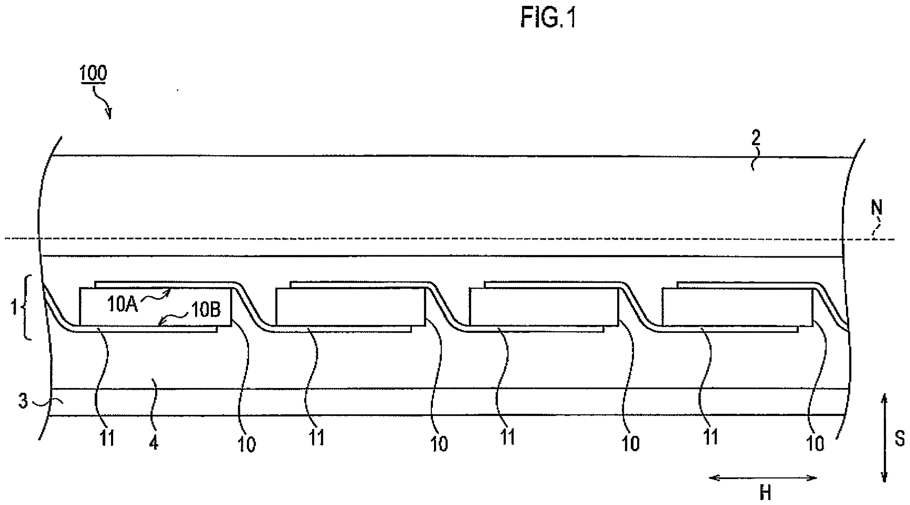

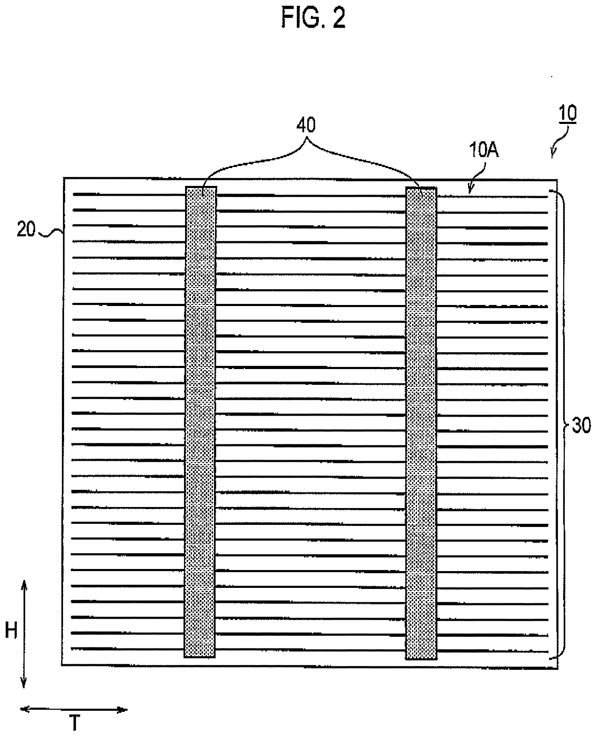

With reference to the drawings, description will be hereinbelow provided for a structure of a solar cell module according to an embodiment of the present invention. Fig. 1 is a side view of a solar cell module 100 according to the embodiment. Fig. 2 is a plan view of a solar cell 10 according to the embodiment.

As shown in Fig. 1, the solar cell module 100 includes a solar cell string 1, a light receiving surface protection member 2, a back surface protection member 3 and a sealing member 4.

The solar cell string 1 is sealed by the sealing member 4 between the light receiving surface protection member 2 and the back surface protection member 3. The solar cell string 1 includes a plurality of solar cells 10 arrayed in an array direction H. The plurality of solar cells 10 are electrically connected to each other by a plurality of wiring members 11.

As shown in Fig. 1, each of the solar cells 10 includes a light receiving surface 10A for receiving light, and a back surface 10B provided on an opposite side to the light receiving surface 10A. Both of the light receiving surface 10A and the back surface 10B are main surfaces of the solar cell 10. The light receiving surface 10A faces the light receiving surface protection member 2. The back surface 10B faces the back surface protection member 3.

The wiring members 11 are electrically connected to the main surfaces of the solar cells 10. A conductive material such as thin-plate-shaped copper, for example, can be used as the wiring members 11. A surface of such a conductive material may be covered with a soft conductive material such as a lead-free solder (for example, $SnAg_{3.0}Cu_{0.5}$).

As shown in Fig. 2, the solar cell 10 includes a photoelectric conversion body 20, a plurality of fine-line electrodes 30 and two connecting electrodes 40.

The photoelectric conversion body 20 generates photogenerated carriers by receiving light. The photogenerated carriers are holes and electrons which the photoelectric conversion body 20 generates by absorbing light. The photoelectric conversion body 20 internally includes a semiconductor junction such as a pn junction or a pin junction. The photoelectric conversion body 20 can be formed by using a general semiconductor material such as a crystalline semiconductor material made of single-crystal Si, polycrystalline Si or the like, or a compound semiconductor material made of GaAs, InP or the like.

The plurality of fine-line electrodes 30 are collecting electrodes that collect photogenerated carriers from the photoelectric conversion body 20. Each of the plurality of fine-line electrodes 30 is formed on the light receiving surface 10A along an orthogonal direction T substantially orthogonal to the array direction H. Each of the fine-line electrodes 30 is formed of a resin conductive paste or a sintered conductive paste (ceramic paste) by using, for example, a printing process or the like. In terms of the dimensions and the total number of the fine-line electrodes 30, an appropriate number can be set in consideration of the size, physical properties and the like of the photoelectric conversion body 20. In the case where the photoelectric conversion body 20 has dimensions of approximately 100 mm square, for example, approximately 50 fine-line electrodes 30 can be formed. A plurality of fine-line electrodes 30 maybe formed on the back surface 10B, though not illustrated. The collecting electrodes may be formed to cover the almost entire back surface 10B. The present invention does not limit the shape of the collecting electrodes formed on the back surface 10B.

The two connecting electrodes 40 are electrodes to which the wiring members 11 are to be connected. Each of the connecting electrodes 4 is formed along the array direction H on the light receiving surface 10A. Each of the connecting electrodes 40 is formed of a resin conductive paste or a sintered conductive paste (ceramic paste) by using, for example, a printing process or the like. In terms of the dimensions and the total number of the connecting electrodes 40, an appropriate number can be set in consideration of the size, physical properties and the like of the photoelectric conversion body 20. Two connecting electrodes 40 are formed on the back surface 10B, thought not illustrated.

The light receiving surface protection member 2 is placed at a side of the light receiving surfaces 10A of the solar cells 10, as shown in Fig. 1. The light receiving surface protection member 2 protects a surface of the solar cell module 100. A material having a thickness of 1 to several mm, such as a light-transmissive chilled glass or a light-transmissive plastic, can be used as the light receiving surface protection member 2.

The back surface protection member 3 is placed at a side of the back surfaces 10B of the solar cells 10. The back surface protection member 3 protects the back surface of the solar cell module 100. A film usable as the back surface protection member 3 is a film having a thickness of several $\mu$m to several mm, such as a resin film made of PET (Polyethylene Terephthalate) or the like, or a laminate film having a structure in which an Al foil is sandwiched between resin films.

The sealing member 4 seals the solar cell string 1 between the light receiving surface protection member 2 and the back surface protection member 3. A light-transmissive resin such as an EVA, EEA, PVB, silicon, urethane, acryl, or epoxy resin can be used as the sealing member 4. A distance between the light receiving surface protection member 2 and the back surface protection member 3 is several hundred $\mu$m to several mm.

Incidentally, an Al flame (not illustrated) can be attached to an outer periphery of the solar cell module 100 described above.

A neutral surface N exists inside the solar cell module 100, as shown in Fig. 1. The neutral surface N is a phantom plan where neither a tensile stress nor a compressive stress acts even when the solar cell module 100 is curved upward or downward. Neither the tensile stress nor the compressive stress caused by the curving of the light receiving surface protection member 2 and the back surface protection member 3 acts on component members located around the neutral surface N. When the light receiving surface protection member 2 and the back surface protection member 3 are curved upward or downward, a component member located at a larger distance from the neutral surface N is subjected to a larger tensile stress or compressive stress.

A position y of the neutral surface N from the surface of the light receiving surface protection member 2 in a vertical direction S that is a direction vertical to the solar cell module 100 is figured out by using the following formula (1) :
[Formula 1]

$$y = \frac{\sum_{i=1}^{n} Ei \times ti \times yi}{\sum_{i=1}^{n} Ei \times ti} \quad \cdots (1)$$

In the formula (1), Ei is an elastic coefficient of an i-th component member from the light receiving surface protection member 2; ti is a thickness of the i-th component member in the vertical direction S; and yi is a distance between the surface of the light receiving surface protection member 2 and the center of the i-th component member in the vertical direction S.

In the present embodiment, the neutral surface N is set to exist inside the light receiving surface protection member 2, in other words, at a side of the light receiving surface of the solar cell string 1. The position of the neutral surface N can be changed according to physical properties and the like of component members constituting the solar cell module 100.

<structure of Solar Cell String>

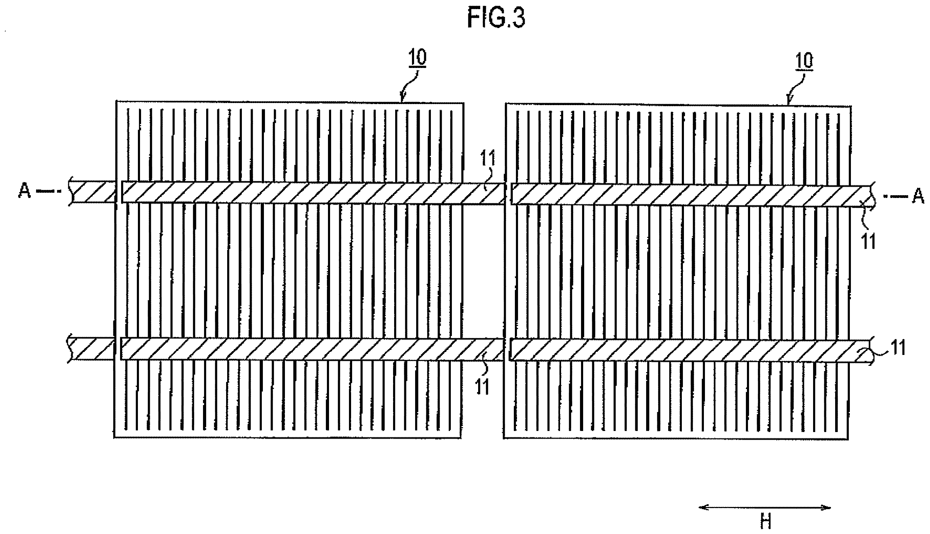

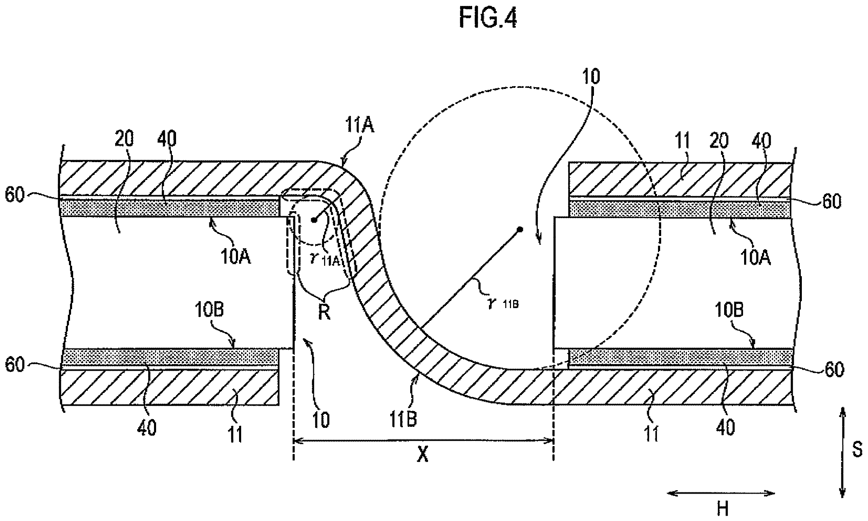

Hereinafter, a structure of the solar cell string according to the embodiment will be described by referring to the drawings. Fig. 3 is a plan view of the solar cell string 1 according to the embodiment. Fig. 4 is a cross sectional view taken along the A-A line in Fig. 3.

As shown in Fig. 3, one solar cell 10 and another solar cell 10 next to the one solar cell 10 are connected to each other by two wiring members 11. Specifically, as shown in Fig. 4, one end portion of each of the wiring members 11 is connected to one of the connecting electrodes 40 formed on the light receiving surface 10A of the one solar cell 10. The other end portion of each of the wiring members 11 is connected to one of the connecting electrodes 40 formed on the back surface 10B of the other solar cell 10.

An adhesive usable for connection includes a resin adhesive in addition a solder. The resin adhesive is preferable cured at a temperature equal to or lower than the melting point of a lead-free solder (approximately 200°C). The usable resin adhesives include, for example, a thermosetting resin adhesive made of an acryl resin, a highly-flexible polyurethane based resin, or the like, and also a two-component reactive adhesive containing a mixture of an epoxy resin, an acryl resin or a urethane resin with a curing agent. The resin adhesive may include a plurality of conductive particles. As the conductive particles, particles of nickel, nickel coated with gold or the like can be used. In the case of using a resin adhesive including no conductive particles, it is preferable to directly connect the wiring members 11 to the connecting electrodes 40 so as to electrically connect the one solar cell 10 and the other solar cell 10 to each other. As shown in Fig. 4, the adhesive forms an adhesive layer 60.

Each of the wiring members 11 includes two bent portions formed between the one solar cell 10 and the other solar cell 10. Specifically, as shown in Fig. 4, the wiring member 11 includes a first bent portion 11A formed near the one solar cell 10 and a second bent portion 11B formed near the other solar cell 10. The wiring member 11 is bent at the first bent portion 11A to extend from around the light receiving surface 10A of the one solar cell 10 toward the back surface protection member 3. In addition, the wiring member 11 is bent at the second bent portion 11B to extend from around the back surface 10B of the other solar cell 10 toward the light receiving surface protection member 2.

In the present embodiment, the first bent portion 11A is located closer to the light receiving surface protection member 2 in the vertical direction S than the second bent portion 11B is. Accordingly, the distance between the neutral surface N and the second bent portion 11B is larger than the distance between the neutral surface N and the first bent portion 11A (see Fig. 1).

A curvature radius $r_{11B}$ of the second bent portion 11B is larger than a curvature radius $r_{11A}$ of the first bent portion 11A. In other words, the wiring member 11 is bent more gently at the first bent portion 11B than at the second bent portion 11A.

Each of the curvature radii r can be calculated from a radius of an inscribed circle of the corresponding bent portion.

<Solar Cell Module Manufacturing Method >

Hereinafter, a solar cell module manufacturing method according to the embodiment will be described by referring to the drawings.

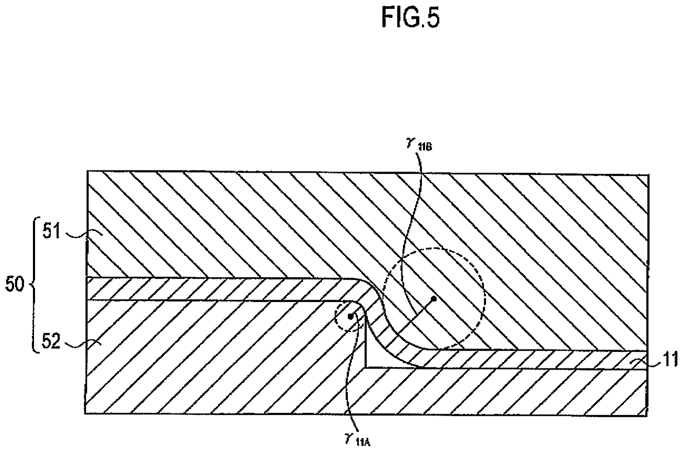

As shown in Fig. 5, a wiring member in a straight line shape is bent by a process using a die 50. More specifically, the wiring member is pressed between a convex portion with the curvature radius $r_{11B}$ formed in an upper die 51 and a convex portion with the curvature radius $r_{11A}$ formed in a lower die 52. With this process, the wiring member 11 having the first bent portion 11A and the second bent portion 11B is formed.

Next, a plurality of solar cells 10 are arrayed. The plurality of solar cells 10 thus arrayed are electrically connected to each other by the wiring members 11. Specifically, one end portions of the wiring members 11 are connected to the connecting electrodes 40 formed on the light receiving surface 10A of the one solar cell 10, whereas the other end portions of the wiring members 11 are connected to the connecting electrodes 44 formed on the back surface 10B of the other solar cell 10. In this way, the solar cell string 1 is formed.

Subsequently, the light receiving surface protection member 2, the sealing member 4, the solar cell string 1, the sealing member 4 and the back surface protection member 3 are stacked in this order on the light receiving surface protection member 2. Next, the sealing member 4 is heated and thereby is cured. In this way, the solar cell module 100 is manufactured.

<Operations and Effects>

In the solar cell module 100 according to the present embodiment, the wiring member 11 includes the first bent portion 11A and the second bent portion 11B formed between the solar cells 10. The second bent portion 11B having a larger distance from the neutral surface N has a larger curvature radius than the first bent portion 11A.

As described above, the wiring member 11 is bent gently at a location far from the neutral surface N. To put it another way, the wiring member 11 is bent gently at a portion to which a large stress is more likely to be applied when the light receiving surface protection member 2 and the back surface protection member 3 are curved upward or downward. Hence, the wiring member 11 can be prevented from being damaged at the second bent portion 11B.

The wiring member 11 is bent sharply at a location close to the neutral surface N. Thus, a space formed between the one solar cell 10 and the other solar cell 10 can be narrowed. Consequently, a packing rate of solar cells 10 in the solar cell module 100 can be increased, so that the conversion efficiency of the solar cell module 100 can be improved. Since the first bent portion 11A is close to the neutral surface N, the tensile stress or compressive stress is less likely to act on the first bent portion 11A than on the second bent portion 11B.

In the solar cell module 100 according to the present embodiment, the one solar cell 10 and the other solar cell 10 are connected to each other by bonding the wiring members 11 thereto with the resin adhesive. The wiring member 11 is bent sharply at the first bent portion 11A. For this reason, a portion of the wiring member 11 from the first bent portion 11A to the second bent portion 11B is located close to the one solar cell 10. In the case of bonding the wiring members 11 by using a solder, a solder pool may be sometimes formed near the first bent portion 11A. As a result, a leak through the solder pool may occur in a region R. In the case of bonding the wiring members 11 by using the resin adhesive, no solder pool is formed. Thus, no leak may occur even when the distance x between the one solar cell 10 and the other solar cell 10 is set to 2 mm or bellow. The bonding with the resin adhesive makes it possible to manufacture the solar cell modules 100 with a high yield. In addition, since an effective area ratio of solar cells can be set to 86% or above with the setting of the distance x to 2 mm or below, the solar cell modules 100 capable of outputting high power can be manufactured.

<Other Embodiments>

As described above, the present invention has been described by using the above embodiment. However, it should not be understood that the description and drawings which constitute parts of this disclosure limit the present invention. From this disclosure, various alternative embodiments, examples, and operation techniques will be easily found by those skilled in the art.

For example, in the foregoing embodiment, each of the fine-line electrodes 30 is formed in a line shape along the orthogonal direction T. However, the shape is not limited to this. Each of the fine-line electrodes 30 may be formed in a wavy line shape or the like.

In the foregoing embodiment, the solar cell 10 includes the connecting electrodes 40, but the solar cell 10 may not includes any connecting electrode 40. In this case, the wiring members 11 are placed directly on the light receiving surface 10A and the back surface 10B.

In this manner, the present invention naturally includes various embodiments not specifically described herein. Accordingly, the technical scope of the present invention should be defined only by the attached claims which are to be interpreted on the basis of the above description. Example

Hereinafter, an example of a solar cell module according to the present invention will be described in detail. The present invention, however, is not limited to the following example, but may be implemented by being appropriately modified without departing from the sprit and scope of the invention.

(Example)

By using the die shown in Fig. 5, two bent portions were formed at a center portion in a straight-line-shaped wiring member. One of the bent portions was set to have a curvature radius of 200 $\mu$m and the other bent portion was set to have a curvature radius of 500 $\mu$m. The number of such prepared wiring members is 18.

Then, 10 solar cells each having dimensions of approximately 100 mm square and a thickness of 200 $\mu$m were prepared. On the light receiving surface of each of the solar cells, 50 fine-line electrodes each having a line width of 80 $\mu$m and two connecting electrodes each having a line width 1.5 mm were formed.

Next, one end portions of the wiring members were connected to the connecting electrodes formed on the light receiving surface of one solar call, and the other end portions of the wiring members were connected to the connecting electrodes formed on the back surface of another solar cell. In this process, the bent portion having the smaller curvature radius was arranged at a side of the light receiving surface of the one solar cell and the bent portion having the larger curvature radius was arranged at a side of the back surface of the other solar cell. The solar cell string was formed by repetition of this process. In the solar cell string, the distance between the solar cells is 1 mm, Accordingly, the total length of the solar cell string in the example is 1009 mm.

Subsequently, EVA, the solar cell string, EVA, a PET film were stacked on a glass substrate. Then, the EVA was heated and thereby was cured. The dimensions of the glass substrate are 1029 mm $\times$ 120 mm. Accordingly, the effective area ratio (solar cell area/glass area) of the solar cell module in the example is 82.6%.

The solar cell module in the example has the neutral surface inside the glass substrate.

**EP 2 320 472 B1**

(Comparative Example 1)

In a comparative example 1, two bent portions of each wiring member were both set to have a curvature radius of 200 μm. Except for this process, the comparative example 1 was prepared by the same processes as the above example. In the comparative example 1, the distance between the solar cells is 0.8 mm. Accordingly, the total length of the solar cell string in the comparative example 1 is 1007 mm.
Since the dimensions of the glass substrate are 1027 mm × 120 mm, the effective area ratio of the solar cell module in the comparative example 1 is 82.7%.
The solar cell module in the comparative example 1 also has the neutral surface inside the glass substrate.

(Comparative Example 2)

In a comparative example 2, two bent portions of each wiring member were both set to have a curvature radius of 300 μm. Except for this process, the comparative example 2 was prepared by the same processes as the above example. In the comparative example 2, the distance between the solar cells is 1.0 mm. Accordingly, the total length of the solar cell string in the comparative example 2 is 1009 mm.
Since the dimensions of the glass substrate are 1029 mm × 120 mm, the effective area ratio of the solar cell module in the comparative example 2 is 82.6%.
The solar cell module in the comparative example 2 also has the neutral surface inside the glass substrate.

(Comparative Example 3)

In a comparative example 3, two bent portions of each wiring member were both set to have a curvature radius of 500 μm. Except for this process, the comparative example 3 was prepared by the same processes as the above example. In the comparative example 3, the distance between the solar cells is 2.0 mm. Accordingly, the total length of the solar cell string in the comparative example 3 is 1018 mm.
Since the dimensions of the glass substrate are 1038 mm × 120 mm, the effective area ratio of the solar cell module in the comparative example 3 is 81.9%.
The solar cell module in the comparative example 3 also has the neutral surface inside the glass substrate.

(Flexural property test)

The solar cell modules in the example and the comparative examples 1 to 3 were tested in flexural property test. Specifically, a center portion of each of the solar cell modules was deformed upward and downward by 10 cm while both end portions of the solar cell module were fixed. The solar cell module was deformed repeatedly in 1000 cycles where one cycle is defined as including upward deformation once and downward deformation once.
Table 1 shows, for each solar cell module, an output power ratio (output power before testing/output power after testing), an effective area ratio, the curvature radius $r_{11A}$ of the bent portion on the light receiving surface side, and the curvature radius $r_{11B}$ of the bent portion on the back surface side.

[Table 1]

| | Output Power Ratio | Effective Area Ratio | Curvature Radius $r_{11A}$ | Curvature Radius $r_{11B}$ |
|---|---|---|---|---|
| Example | 99 | 82.6 | 200 | 500 |
| Comparative Example 1 | 93 | 82.7 | 200 | 200 |
| Comparative Example 2 | 97 | 82.6 | 300 | 300 |
| Comparative Example 3 | 99 | B1.9 | 500 | 500 |

As shown in Table 1, decreases in the output power were found in the comparative example 1 and the comparative example 2. For this reason, the wiring members ware taken out from the comparative example 1 and the comparative example 2 and then were observed. In the comparative example 1, it was found that 7 of the 18 wiring members were broken. In the comparative example2, it was found that two of the 18 wiring members were broken. These breakages were caused because metal fatigue occurred in the bent portion of the wiring member on the back

7

surface side which was sharply bent at a location far from the neutral surface.

In contrast, no decrease in the output power was found in the example and the comparative example 3. In other words, it was confirmed that the output power was able to be maintained at the same level before and after the flexural property test. This is because no metal fatigue occurred in the bent portion of the wiring member on the back surface side which had the larger curvature radius $r_{11B}$, that is, was bent gently at the location far from the neutral surface.

The reason why the comparative example 3 has a low effective area ratio is that both the curvature radius $r_{11A}$ and the curvature radius $r_{11B}$ are set large. In contrast, the example has a high effective area ratio because the curvature radius $r_{11A}$ of the bent portion near the neutral surface is set small.

On the basis of the above findings, it was confirmed that setting the curvature radius $r_{11B}$ to be larger than the curvature radius $r_{11A}$ enables increase in the effective area ratio and prevention of wiring member breakage.

INDUSTRIAL APPLICABILITY

As described above, the solar cell module according to the present invention enables provision of solar cell modules capable of achieving improvement in conversion efficiency, and therefore is usable for manufacturing solar cell modules.

EXPLANATION OF REFERENCE NUMERALS

1     solar cell string
2     light receiving surface protection member
3     back surface protection member
4     sealing member
10    solar cell
10A   light receiving surface
10B   back surface
11    wiring member
11A   first bent portion
11B   second bent portion
20    photoelectric conversion body
30    fine-line electrode
40    connecting electrode
50    die
51    upper die
52    lower die
60    adhesive layer
100   solar cell module

**Claims**

1.  A solar cell module, comprising a first solar cell (10) and a second solar cell (10) sealed between a light receiving surface protection member (2) and a back surface protection member (3) and electrically connected to each other by a wiring member (11),
wherein
each of the first solar cell and the second solar cell includes a light receiving surface (10A) facing the light receiving surface protection member and a back surface (10B) provided on an opposite side to the light receiving surface and facing the back surface protection member,
the wiring member is arranged on the light receiving surface of the first solar cell and the back surface of the second solar cell so as to bridge therebetween,
the wiring member includes two bent potions (11A, 11B) formed between the first solar cell and the second solar cell, and
**characterized in that**;
one of the two bent portions having a larger distance from a neutral surface has a larger curvature radius than the other bent portion.

**2.** The solar cell module according to claim 1, wherein the wiring member is bonded with a resin adhesive to connect the first solar cell and the second solar cell to each other.

**Patentansprüche**

**1.** Solarzellenmodul, umfassend eine erste Solarzelle (10) und eine zweite Solarzelle (10), die zwischen einem Licht empfangenden Oberflächenschutzelement (2) und einem Rückseitenschutzelement (3) abgedichtet und durch ein Verdrahtungselement (11) miteinander elektrisch verbunden sind,

worin

jede der ersten Solarzelle und der zweiten Solarzelle eine Licht empfangende Oberfläche (10A), welche dem Licht empfangenden Oberflächenschutzelement zugewandt ist, und eine Rückseite (10B), welche auf einer, der Licht empfangenden Oberfläche entgegengesetzten Seite vorgesehen und dem Rückseitenschutzelement zugewandt ist, umfasst,

das Verdrahtungselement auf der Licht empfangenden Oberfläche der ersten Solarzelle und der Rückseite der zweiten Solarzelle so angeordnet ist, um zwischen diesen eine Brücke zu bilden,

das Verdrahtungselement zwei gebogene Abschnitte (11A, 11 B) umfasst, die zwischen der ersten Solarzelle und der zweiten Solarzelle ausgebildet sind, und

**dadurch gekennzeichnet, dass**:

einer der zwei gebogenen Abschnitte, der einen größeren Abstand von einer neutralen Oberfläche aufweist, einen größeren Krümmungsradius als der andere gebogene Abschnitt aufweist.

**2.** Solarzellenmodul gemäß Anspruch 1, worin das Verdrahtungselement mit einem Harzklebstoff haftschlüssig verbunden ist, um die erste Solarzelle und die zweite Solarzelle miteinander zu verbinden.

**Revendications**

**1.** Module de cellules solaires, comprenant une première cellule solaire (10) et une seconde cellule solaire (10) scellées entre un élément de protection de surface de réception de lumière (2) et un élément de protection de surface arrière (3) et connectées électriquement l'une à l'autre par un élément de câblage (11), dans lequel

chacune parmi la première cellule solaire et la seconde cellule solaire comprend une surface de réception de lumière (10A) en vis-à-vis de l'élément de protection de surface de réception de lumière et une surface arrière (10B) agencée sur un côté opposé à la surface de réception de lumière et en vis-à-vis de l'élément de protection de surface arrière,

l'élément de câblage est agencé sur la surface de réception de lumière de la première cellule solaire et la surface arrière de la seconde cellule solaire de manière à les relier,

l'élément de câblage comprend deux parties incurvées (11A, 11B) formées entre la première cellule solaire et la seconde cellule solaire, et

**caractérisé en ce que** ;

l'une des deux parties incurvées ayant une plus grande distance par rapport à une surface neutre a un rayon de courbure plus grand que l'autre partie incurvée.

**2.** Module de cellules solaires selon la revendication 1, dans lequel l'élément de câblage est fixé à l'aide d'un adhésif en résine pour relier l'une à l'autre la première cellule solaire et la seconde cellule solaire.

FIG.1

EP 2 320 472 B1

# FIG. 2

## FIG.3

EP 2 320 472 B1

EP 2 320 472 B1

13

FIG.4

# FIG.5

EP 2 320 472 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005191125 A

- EP 0499075 A1